# EUROPEAN PATENT APPLICATION

(11) **EP 4 273 918 A1**
(43) Date of publication of application: **08.11.2023**
(21) Application number: 22171788.7
(22) Date of filing: 05.05.2022
(51) Int. Cl.: H01L 23/00, H01L 23/053, H01L 23/24, H01L 23/31, H01L 23/04, H01L 23/16

(54) **A SEMICONDUCTOR PACKAGE COMPRISING STRUCTURES CONFIGURED TO WITHSTAND A CHANGE OF THE VOLUME OF AN POTTING COMPOUND**

(71) Applicant: Infineon Technologies AG, 85579 Neubiberg (DE)
(72) Inventor: BAYER, Christoph, 97320 Albertshofen (DE)
(74) Representative: Lambsdorff & Lange Patentanwälte Partnerschaft mbB

(57) **Abstract**

A semiconductor package (10) comprising a die carrier (3), at least one semiconductor die (4) disposed on the die carrier (3), a potting compound (6) at least partially covering the die carrier (3) and the semiconductor die (4), and at least one structure (8) that is configured to withstand a change of the volume of the potting compound (6) occurring under changed external conditions in a targeted manner.

## Description

### TECHNICAL FIELD

The present disclosure is related to a semiconductor package comprising at least one structure which is configured to withstand a change of the volume of an potting compound.

### BACKGROUND

A semiconductor package usually contains a die carrier, at least one semiconductor die disposed on the die carrier, an potting compound at least partially covering the die carrier and the semiconductor die, and usually a housing or a frame with the before mentioned potting compound filled into the interior thereof.

In the course of its use, the semiconductor package is exposed to changing environmental influences, in particular changing humidity, pressure, or especially temperatures. These can cause the encapsulation to change its volume, i.e. either shrink or expand. Expansion and shrinkage of the potting compound of a power electronic frame module, caused for example by the effect of a changing temperature, results in mechanical stresses in the potting compound. As a consequence, the encapsulation may undesirably detach from other parts such as the circuit carrier, the die pad or the semiconductor die, resulting in cracks or delaminations or spaces that allow humidity to diffuse in and damage the insulation property pf the potting material..

For these and other reasons there is a need for the present disclosure.

### SUMMARY

An aspect of the present disclosure is related to a semiconductor package, comprising a die carrier, at least one semiconductor die disposed on the die carrier, an potting compound at least partially covering the die carrier and the semiconductor die, and at least one structure that is configured to withstand a change of the volume of the potting compound occurring under changed external conditions in a targeted manner.

The invention thus refers to expansion structures or expansion joints, or deliberately placed weak points, which make it possible to achieve higher lifetimes and lower damage effects when the potting compound in a power module ages or undergoes, i.e. temperature change, ageing or expansion and shrinkage. Changes in the volume of the potting material can be absorbed with the built-in structures embodiments of which will be described in more detail in the following.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a cross-sectional side view on a semiconductor package in which the potting compound comprises an upper layer comprising thinned sections, or sections that are produced with a flexible material compared to the rest of the extra layer.
Fig. 2 comprises Fig. 2A and 2B and shows cross-sectional side views of the semiconductor package of Fig. 1 presenting the mode of action of the thinned layers with expanding potting compound (A) and shrinking potting compound (B) .
Fig. 3 comprises Fig. 3A and 3B and shows cross-sectional side views of a semiconductor package comprising cavities in the potting compound (A) and the mode of action of the cavities in the case of a shrinking potting compound (B) .
Fig. 4 comprises Fig. 4A and 4B and shows cross-sectional side views of a semiconductor package comprising a movable foil disposed without adhesion at an inner wall of a package housing (A) and the mode of action of the foil in the case of a shrinking potting compound (B).
Fig. 5 comprises Fig. 5A and 5B and shows cross-sectional side views of a semiconductor package comprising a movable foil decoupled from the package housing and being movable in a lateral direction (A) and a similar embodiment with a foil comprising an upper curved end section (B).
Fig. 6 shows a cross-sectional side view of a semiconductor package comprising a movable foil which is part of the package housing and is movable in a lateral direction.
Fig. 7 comprises Fig. 7A and 7B and shows cross-sectional side views of a semiconductor package comprising a housing cover comprising a plurality of portions which project into the potting compound, the at least one portion comprising a foil or layer which is disposed without adhesion at the at least one portion (A) and the mode of action of the portions in the case of a shrinking potting compound (B).

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

In the following, different embodiments of semiconductor packages will be described all of them containing one or more structures which are configured to enable a change of the volume of the potting compound occurring under changed external conditions in a targeted manner. The change of the volume of the potting compound can be either an expansion or a shrinkage. These structures can, for example, be introduced as expansion structures at positions in the potting compound that are not directly critical in terms of insulation or corrosion.

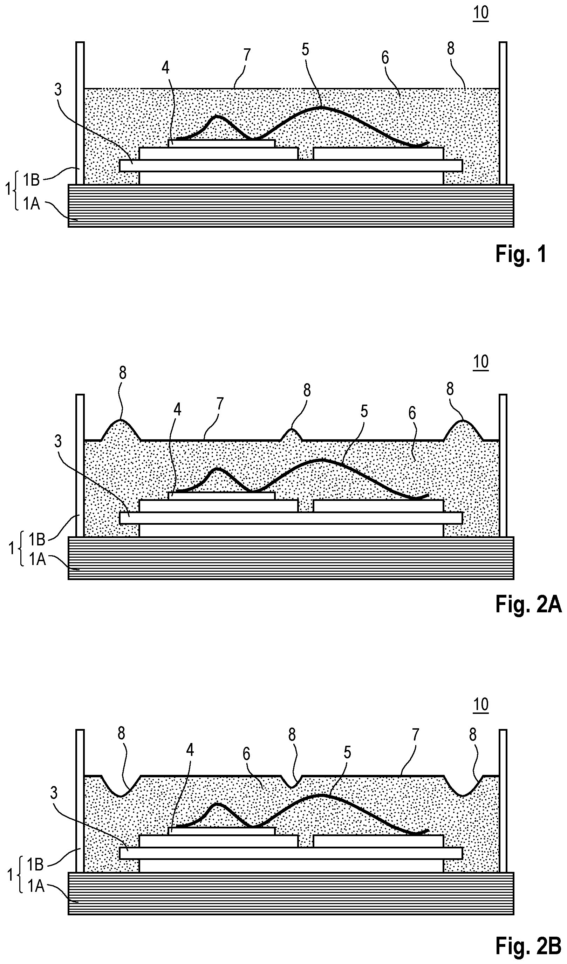

Fig. 1 shows a cross-sectional side view on a semiconductor package in which the potting compound comprises an upper layer comprising thinned sections.

More specifically, Fig. 1 shows a semiconductor package 10 comprising a housing 1 composed of a base plate 1A and a frame 1B, a die carrier 3, a semiconductor die 4 disposed on the die carrier 3, a potting compound 6 filled in the interior of the housing 1 and at least partially covering the die carrier 3 and the semiconductor die 4. The semiconductor die 4 can, for example, be a power transistor die. A bond wire 5 is connected with a contact pad of the semiconductor die 4. The potting compound 6 can, for example, be any kind of polymer material like, for example, silicone or a resin like an epoxy resin.

The potting compound 6 is covered at an upper surface thereof by a layer 7, and the structures are formed by three thin membranes 8 of an elastic material inserted in the layer 7. In the simplest case, these can be formed by thinned sections 8 of the layer 7. The layer 7 itself can, for example, be a polymer layer of a preferably hard material like, for example, of PET or PTFE. The thickness of the layer 7 can, for example, in a range from 0.5 mm to 1.5 mm. The thickness of the membranes 8, in particular the thinned sections, can, for example, be in a range from 1 to 10 µm. The membranes 8 can be evenly distributed over the layer 7. Of course, the number three of the membranes is only exemplary. There can be more or less than three membranes. The thin membranes 8 can follow the volume change of the potting compound 6 when the potting compound 6 expands or shrinks as will be shown in the following.

Fig. 2 comprises Fig. 2A and 2B and shows cross-sectional side views of the semiconductor package of Fig. 1 presenting the mode of action of the thinned layers with expanding potting compound (A) and shrinking potting compound (B) .

The potting compound used is characterized by a specific curing temperature. The potting compound has been hardened during its manufacture, i.e. it has undergone a transition from a liquid material to a solid state. This transition took place at the curing temperature. If the ambient temperature is above or below this curing temperature when the semiconductor package is in use, the potting compound can either expand or shrink.

Fig. 2A illustrates the mode of operation in case the ambient temperature is above the curing temperature in which case the potting compound 6 expands. This expansion can now take place in a controlled manner, namely so that at the positions of the thin membranes 8 the potting compound 6 bulges the membranes 8 outwards. The added volume of these resulting bulges corresponds to the total expansion volume of the potting compound 6.

Fig. 2B on the other hand illustrates the mode of operation in case the ambient temperature is below the curing temperature in which case the potting compound 6 shrinks. This shrinkage can now take place in a controlled manner, namely so that at the positions of the thin membranes 8 the potting compound 6 bulges the membranes 8 inwards. The added volume of these resulting bulges corresponds to the total shrinkage volume of the potting compound 6.

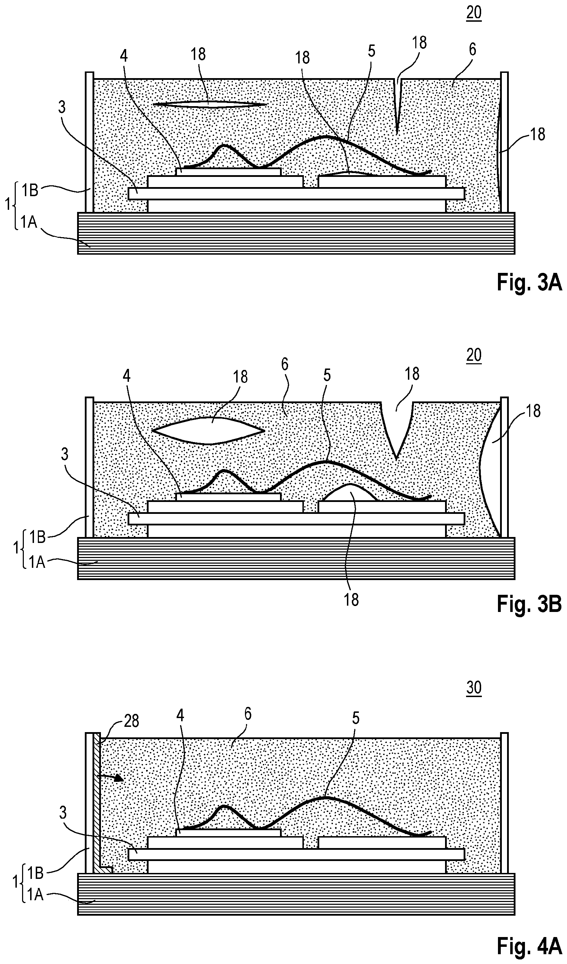

Fig. 3 comprises Fig. 3A and 3B and shows cross-sectional side views of a semiconductor package comprising cavities in the potting compound (A) and the mode of action of the cavities in the case of a shrinking potting compound (B) .

More specifically, Fig. 3 shows a semiconductor package 20 similar to the one shown in Fig. 1 so that the explanations for elements with identical reference numbers are not repeated here. As a difference the semiconductor package 20 comprises a plurality of cavities 18 distributed within the potting compound. The cavities 18 can be formed by a plastic foil like, for example, similar to the one used in plastic wraps. Furthermore the cavities can be filled with air so that expanding or shrinking of the cavities 18 is accompanied by a resilient effect. Otherwise the other hand, a slight vacuum may also prevail in the cavities 18.

Fig. 3B illustrates the mode of operation in case the ambient temperature is below the curing temperature in which case the potting compound 6 shrinks. This shrinkage can now again take place in a controlled manner, namely so that the cavities 18 absorb the shrinkage of the potting material 6 by expanding.

The cavities 18 can also be located at an inner wall of the housing 1 so that the cavity 18 is partially bounded by the inner wall. In general, the cavities can be disposed elsewhere within the potting material 6, but not between two electrodes and also not at an edge of the die pad.

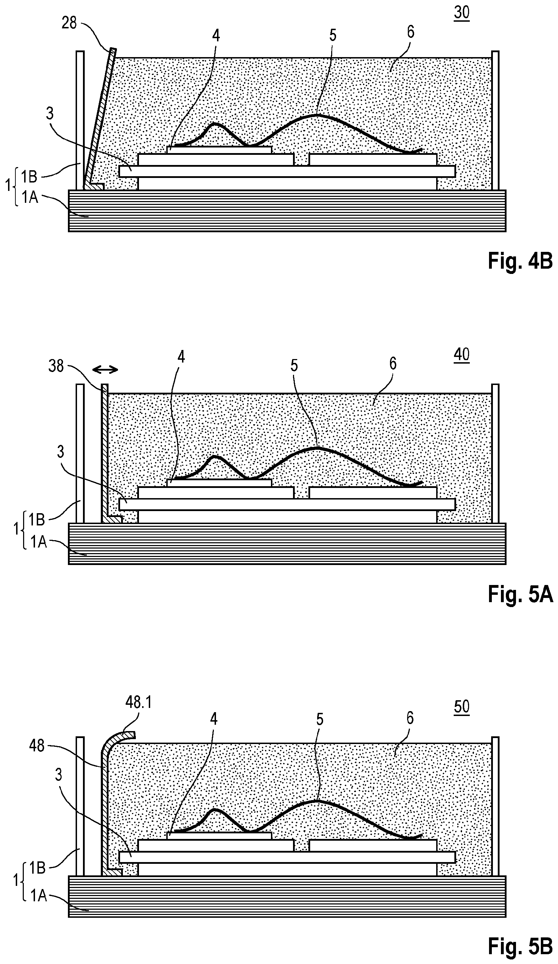

Fig. 4 comprises Fig. 4A and 4B and shows cross-sectional side views of a semiconductor package comprising a movable foil disposed without adhesion at an inner wall of a package housing (A) and the mode of action of the foil in the case of a shrinking potting compound (B).

More specifically, Fig. 4A shows a semiconductor package 30 similar to the one shown in Fig. 1 so that the explanations for elements with identical reference numbers are not repeated here. As a difference the semiconductor package 30 comprises a movable foil 28 which is attached without adhesion at an inner wall of the housing 1. The movable foil 28 may comprise a lower horizontal stationary part and a vertical movable part which is connected to the lower horizontal part. The vertical part of the foil 28 can, for example, be inserted into an opening of the lower horizontal part of the foil 28. Before filling in the potting material 6, the foil can be attached to the inner wall of the housing 1 by wetting it with a liquid such as distilled water, which liquid later evaporates. As to the material of the foil 28, it can, for example, be made of a material similar to conventional overhead projector transparencies or comparable relative hard and stable foil materials.

Fig. 4B illustrates the mode of operation in case the ambient temperature is below the curing temperature in which case the potting compound 6 shrinks. This shrinkage can now again take place in a controlled manner, namely so that the vertical movable part of the foil 28 detaches itself from the inner wall of the housing 11 and tilts into the potting material 6 as indicated by the arrow. The tilt angle depends on the amount of shrinkage of the potting compound 6.

Fig. 5 comprises Fig. 5A and 5B and shows cross-sectional side views of a semiconductor package comprising a movable foil decoupled from the package housing and being movable in a lateral direction (A) and a similar embodiment with a foil comprising an upper curved end section (B).

More specifically, Fig. 5A shows a semiconductor package 40 similar to the one shown in Fig. 1 so that the explanations for elements with identical reference numbers are not repeated here. As a difference the semiconductor package 40 comprises a movable foil 38 which is decoupled from the housing 1 and is movable in a lateral direction as indicated by the arrow. Similar to the movable foil 28 of Fig. 4, the movable foil 38 may as well comprise a lower horizontal part and a vertical part which is connected to the lower horizontal part. The vertical part of the foil 38 can, for example, be inserted into an opening of the lower horizontal part of the foil 38. In this case, however, both the horizontal and the vertical part are laterally movable. As to the material of the foil 38, it can, for example, similar to the foil 28 of Fig. 4 be made of a material similar to conventional overhead projector transparencies or comparable relative hard and stable foil materials. The illustration in Fig. 5A, for example, shows an initial position at the curing temperature. This embodiment is thus suitable for both an expanding and a shrinking potting compound.

Fig. 5B shows a semiconductor package 50 similar to the one shown in Fig. 5A. As a difference the semiconductor package 50 comprises a movable foil 48 which comprises an upper curved end section 48.1. In this end section 48.1, the foil 48 is bent towards the potting material 6 so as to embrace the potting material 6.

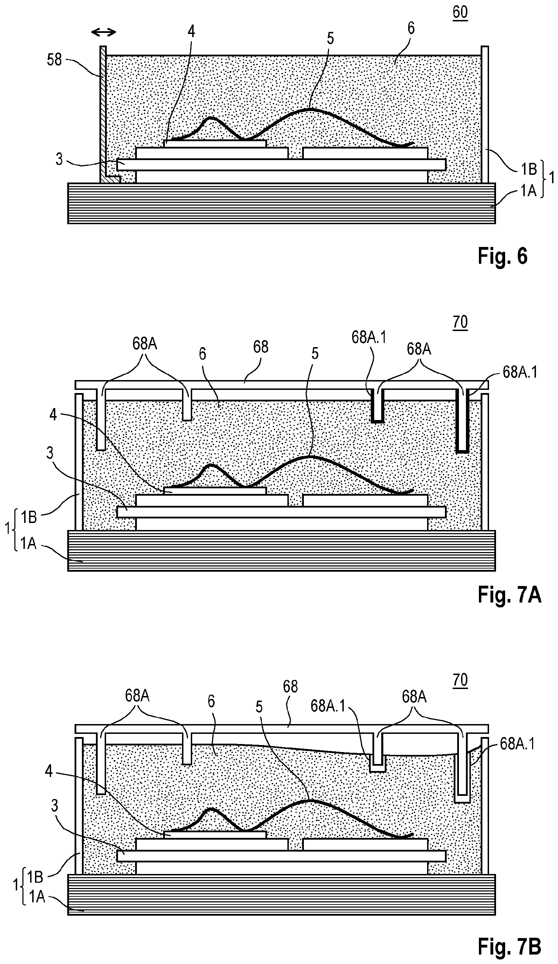

Fig. 6 shows a cross-sectional side view of a semiconductor package comprising a movable foil which is part of the package housing and is movable in a lateral direction.

More specifically, Fig. 6 shows a semiconductor package 60 similar to the one shown in Fig. 1 so that the explanations for elements with identical reference numbers are not repeated here. As a difference the semiconductor package 60 comprises a movable foil 58 which is part of the package housing and is movable in a lateral direction as indicated by the arrow. Similar to the movable foils 28 and 38 of Figs. 4 and 5, the movable foil 58 may as well comprise a lower horizontal part and a vertical part which is connected to the lower horizontal part. The vertical part of the foil 58 can, for example, be inserted into an opening of the lower horizontal part of the foil 58. In this case, however, both the horizontal and the vertical part are laterally movable. As to the material of the foil 58, it can, for example, similar to the foils 28 38 of Figs. 4 and 5 be made of a material similar to conventional overhead projector transparencies or comparable relative hard and stable foil materials. The illustration in Fig. 6A, for example, shows an initial position at the curing temperature. This embodiment is thus suitable for both an expanding and a shrinking potting compound. Since the foil 58 is elastic, a mechanically stable part 1 of the housing is still required.

Fig. 7 comprises Fig. 7A and 7B and shows cross-sectional side views of a semiconductor package comprising a housing cover comprising a plurality of portions which project into the potting compound, the at least one portion comprising a foil or layer which is disposed without adhesion at the at least one portion (A) and the mode of action of the portions in the case of a shrinking potting compound (B).

More specifically, Fig. 7A shows a semiconductor package 70 similar to the one shown in Fig. 1 so that the explanations for elements with identical reference numbers are not repeated here. As a difference the semiconductor package 70 comprises a housing cover 68 comprising a plurality of portions 68A projecting into the potting material, wherein a part of the portions 68A comprise a foil or layer 68A.1 which is disposed without adhesion at the respective portion 68A.

Fig. 7B illustrates the mode of operation in case the ambient temperature is below the curing temperature in which case the potting compound 6 shrinks. This shrinkage can now take place in a controlled manner, namely so that the layers 68A.1 withdraw from the sections 68 into the potting material.

### EXAMPLES

In the following specific examples of the present disclosure are described.

Example 1 is a semiconductor package comprising a die carrier, at least one semiconductor die disposed on the die carrier, a potting compound at least partially covering the die carrier and the semiconductor die, and at least one structure that is configured to withstand a change of the volume of the potting compound occurring under changed external conditions in a targeted manner.

Example 2 is a semiconductor package according to Example 1, further comprising a housing, wherein the potting compound is filled into the interior of the housing.

Example 3 is a semiconductor package according to Example 1 or 2, wherein the at least one structure is formed in or at the potting compound.

Example 4 is a semiconductor package according to Example 3, wherein the at least one structure is formed at a surface of the potting compound, the surface being remote from the die carrier.

Example 5 is a semiconductor package according to Example 4, wherein the potting compound is covered at the surface by a layer, and the at least one structure is formed by a thin membrane inserted in the layer.

Example 6 is a semiconductor package according to Example 4 or 5, comprising a plurality of thinned layers distributed over the layer.

Example 7 is a semiconductor package according to Example 1 or 2, wherein the at least one structure is formed by at least one cavity in the potting compound.

Example 8 is a semiconductor package according to Example 7, comprising a plurality of cavities distributed within the potting compound.

Example 9 is a semiconductor package according to Examples 2 and 8, wherein at least one cavity is located at an inner wall of the housing so that the cavity is partially bounded by the inner wall.

Example 10 is a semiconductor package according to any one of the preceding Examples, wherein the at least one structure is formed by a movable foil.

Example 11 is a semiconductor package according to Examples 2 and 10, wherein the foil is disposed without adhesion at an inner wall of the housing.

Example 12 is a semiconductor package according to Examples 2 and 10, wherein the foil is decoupled from the housing and is movable in a lateral direction.

Example 13 is a semiconductor package according to Examples 2 and 10, wherein the foil is part of the housing and is movable in a lateral direction.

Example 14 is a semiconductor package according to Example 1 or 2, further comprising a housing cover comprising at least one portion which projects into the potting compound, the at least one portion comprising a foil or layer which is disposed without adhesion at the at least one portion.

Example 15 is a semiconductor package according to Example 14, further comprising a plurality of portions projecting into the potting material, wherein a part of the portions or all portions comprise a foil or layer which is disposed without adhesion at the respective portion.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (10), comprising
a die carrier (3);
at least one semiconductor die (4) disposed on the die carrier (3);
a potting compound (6) at least partially covering the die carrier (3) and the semiconductor die (4); and
at least one structure (8) that is configured to withstand a change of the volume of the potting compound (6) occurring under changed external conditions in a targeted manner.

2. The semiconductor package (10) according to any one of the preceding claims, further comprising
a housing (1), wherein the potting compound (6) is filled into the interior of the housing (1).

3. The semiconductor package (10) according to claim 1 or 2, wherein
the at least one structure is formed in or at the potting compound (6).

4. The semiconductor package (10) according to claim 3, wherein
the at least one structure (8) is formed at a surface of the potting compound (6), the surface being remote from the die carrier (3).

5. The semiconductor package (10) according to claim 4, wherein
the potting compound (6) is covered at the surface by a layer (7), and the at least one structure (8) is formed by a thin membrane (8) inserted in the layer (7).

6. The semiconductor package (10) according to claim 4 or 5, comprising
a plurality of thinned layers (8) distributed over the layer (7) .

7. The semiconductor package (20) according to claim 1 or 2, wherein
the at least one structure (18) is formed by at least one cavity (18) in the potting compound (6).

8. The semiconductor package (20) according to claim 7, comprising
a plurality of cavities (18) distributed within the potting compound (6).

9. The semiconductor package (20) according to claims 2 and 8, wherein
at least one cavity (18) is located at an inner wall of the housing (1) so that the cavity (18) is partially bounded by the inner wall.

10. The semiconductor package (30) according to any one of the preceding claims, wherein
the at least one structure (28) is formed by a movable foil (28) .

11. The semiconductor package (30) according to claims 2 and 10, wherein
the foil (28) is disposed without adhesion at an inner wall of the housing (1).

12. The semiconductor package (40) according to claims 2 and 10, wherein
the foil (38) is decoupled from the housing (1) and is movable in a lateral direction.

13. The semiconductor package (60) according to claims 2 and 10, wherein
the foil (58) is part of the housing and is movable in a lateral direction.

14. The semiconductor package (70) according to claim 1 or 2, further comprising
a housing cover (68) comprising at least one portion (68A) which projects into the potting compound (6), the at least one portion (68A) comprising a foil or layer (68A.1) which is disposed without adhesion at the at least one portion (68A).

15. The semiconductor package (70) according to claim 14, further comprising
a plurality of portions (68A) projecting into the potting material (6), wherein a part of the portions (68A) or all portions (68A) comprise a foil or layer (68A.1) which is disposed without adhesion at the respective portion (68A).
